Europäisches Patentamt

European Patent Office

Office européen des brevets

(11) Publication number: **0 212 268 B1**

(12) **EUROPEAN PATENT SPECIFICATION**

(45) Date of publication of patent specification: **23.09.92**  (51) Int. Cl.⁵: **G01R 31/28**, G06F 11/26

(21) Application number: **86109824.2**

(22) Date of filing: **17.07.86**

(54) **Evaluation facilitating circuit device.**

(30) Priority: **23.08.85 JP 184040/85**

(43) Date of publication of application:
**04.03.87 Bulletin  87/10**

(45) Publication of the grant of the patent:
**23.09.92 Bulletin  92/39**

(84) Designated Contracting States:
**DE FR GB**

(56) References cited:
**EP-A- 0 077 237**
**US-A- 4 216 539**

(73) Proprietor: **KABUSHIKI KAISHA TOSHIBA**
**72, Horikawa-cho Saiwai-ku**
**Kawasaki-shi Kanagawa-ken 210(JP)**

(72) Inventor: **Yaguchi, Toshijuki**
**Toshiba Kikuna-ryo 217 Oomamedo-cho**
**Kouhoku-ku**
**Yokohama-shi Kanagawa-ken(JP)**

(74) Representative: **Lehn, Werner, Dipl.-Ing. et al**
**Hoffmann, Eitle & Partner Patentanwälte Ar-**
**abellastrasse 4**
**W-8000 München 81(DE)**

## Description

## BACKGROUND OF THE INVENTION

### Field of the Invention

The present invention relates to an evaluation facilitating circuit device for checking logical signal levels of each node of a logical circuit consisting of such as LSI circuits.

### Description of the Prior Art

Conventionally, checking for simple logical circuits was carried out by use of a synchroscope or a tester, so as to detect logical signal levels at each node of the logical circuit, with a probe or probes being contacted to each node.

However, when a logical circuit becomes complex as a result of the fact that it is constructed by LSI integrated circuits, it can no longer be easily checked by the method described above.

In order to deal with this problem, it is normal that a check circuit is often incorporated in the logical circuit to be checked. Some techniques for overcoming the problem have heretofore been proposed; e.g. a circuit system for checking logical levels at each node of a logical circuit having latches to be used for a sequential circuit connected in series as in the case of LSSD, or pads provided on the LSI circuits to which a probe or stylus for checking the logical circuit is directly contacted. These techniques have, however, the drawbacks that these latches and pads are to be arranged irregularly in the LSI circuits.

Particularly, a recent predominating trend is that designs of the LSI circuits are being carried out by the use of automatic arrangement and wiring programs, when this approach is used, however, it becomes extremely difficult for the latches and pads for which checks are required for identification on the LSI circuits, while the size of the integrated circuits becomes also large.

On the other hand, another method has also been proposed recently wherein internal nodes of a logical circuit are directly checked by the use of a EB tester. In this method as well, however, only relative potentials can be obtained and checking of logical circuits are not necessarily satisfactory.

EP-A-0077237 describes a digital tester local memory data storage system which includes a switching circuit having a local memory as well as a set of control switches for selecting test pins, threshold levels, etc., and a driver/detector pair for each data channel in the test unit. Information is exchanged between the switching circuit and a circuit board under test by means of test fixture pins that connect the data channels with nodes on the circuit board.

In operation, the local memories within the switching circuit are loaded with test vectors to be applied to the various nodes on the board during a test. These test vectors are generated within a control computer. After the memories are loaded, the necessary data channels are selectively enabled by means of control switches in the switching circuit. Stimulus signals are applied to the circuit board by means of the selected data channels in the switching circuit. The responses of the components on the board to the applied stimulus signals are compared with expected results to determine whether the components are operating properly. This comparison is performed within the switching circuit using the detectors of the selected data channels.

## SUMMARY OF THE INVENTION

It is an object of the present invention therefore to overcome the drawbacks described above and to provide an evaluation facilitating circuit device in which checking of each node of a logical circuit can be facilitated as well as improvement in the integration of a logical circuit and compactness in the logical circuit.

It is another object of the present invention to provide an evaluation facilitating circuit device having a plurality of latch circuits arranged in a matrix array in which signal levels at each node of a logical circuit to be checked are latched in the latch circuits at the same time so as to easily check the logical conditions of the logical circuit at a certain time point.

The above objects are solved according to the present invention by an evaluation facilitating circuit device for checking logical signal levels of each node of a logical circuit, comprising:

a data hold circuit having a plurality of latch circuits arranged in a matrix array for latching signal levels in the latch circuits in accordance with a control signal and address signals; and

a data hold and transfer control circuit for controlling the output of the signal level retained in the latch circuits of said data hold circuit in accordance with a data hold signal and system clock signals, characterized in that said data hold circuit receives the signal levels from each of the nodes in the logical circuit to be checked and said data hold and transfer circuit produces the control signal and the address signals and controls the output of the signal level retained in the latch circuits of said data hold circuit in accordance with the data hold signal from the logical circuit to be checked, the system clock signals from the logical circuit to be checked and address information from an external source.

These objects, features and advantages of the invention will be better understood from the following description with reference to the accompanying drawings.

## BRIEF DESCRIPTION OF THE DRAWINGS

Fig. 1 is an overall circuit construction of the evaluation facilitating circuit device embodying the present invention, connected to a logical circuit to be checked,

Fig. 2 is a detailed circuit construction of the data hold circuit of Fig. 1, and

Fig. 3 illustrates a detailed circuit construction of the data hold and transfer control circuit of Fig. 1.

## DESCRIPTION OF THE PREFERRED EMBODIMENT

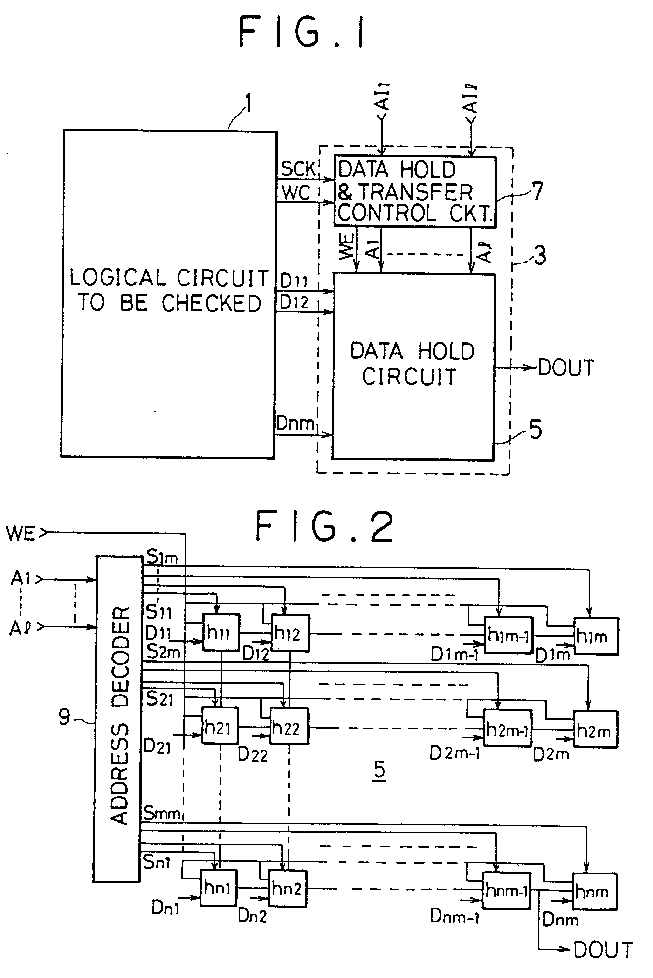

Referring to Fig. 1, the evaluation facilitating circuit 3 embodying the present invention is connected to a logical circuit 1 to be checked, so as to latch and check logical signal levels or the logical conditions of each node of the logical circuit 1 through the evaluation facilitating circuit 3. The logical circuit 1 may be the one having any circuit construction.

The evaluation facilitating circuit 3 comprises a data hold circuit 5 which receives and latches signal levels from each node of the logical circuit 1 through data lines $D_{11}$, $D_{12}$, ... $D_{nm}$ from the circuit 1, while address signals $A_1$ to $A_\ell$ and a write signal WE are applied from a data hold and transfer control circuit 7, so as to produce an output signal $D_{out}$ from the data hold circuit 5.

Address information $AI_1$ to $AI_\ell$ are supplied from outside to the data hold and transfer control circuit 7, while a system clock signal SCK and a data hold signal WC are supplied thereto from the logical circuit 1.

The data hold circuit 5 comprises, as shown in Fig. 2, an address decoder 9 for decoding the address signals $A_1$ to $A_\ell$ supplied from the data hold and transfer control circuit 7, a plurality of latch circuits $h_{11}$, $h_{12}$, ... $h_{1m}$, $h_{21}$, $h_{22}$ ... $h_{2m}$, $h_{n1}$, $h_{n2}$ ... $h_{nm}$, arranged in an array of m x n matrix elements, each of which is designated by each of the output signals $S_{11}$, $S_{12}$, ... $S_{1m}$, $S_{21}$, ... $S_{2m}$, $S_{n1}$ ... $S_{nm}$ from the address decoder 9. This array structure of the latch circuits $h_{11}$ to $h_{nm}$ enables easy integration and compactness of the circuits and it also enables easy checking of the circuits by human eyes.

The data lines $D_{11}$, $D_{12}$ ... $D_{nm}$ from the logical circuit 1 are connected to each of the latch circuits $h_{11}$ to $h_{nm}$ and each of the latch circuits is supplied with the write signal WE in common.

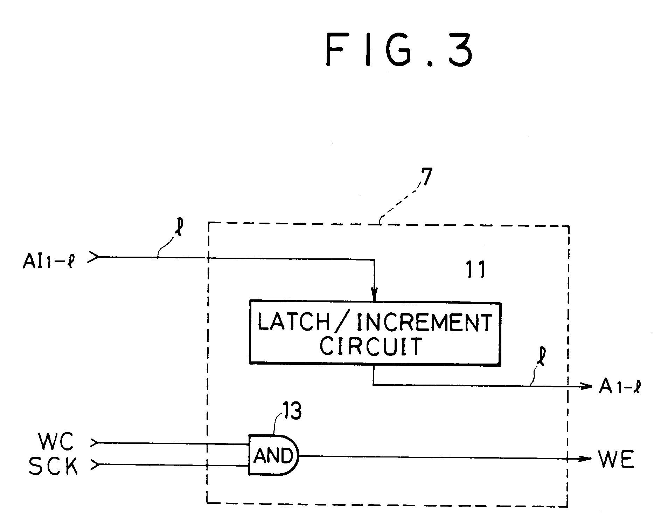

Fig. 3 shows one embodiment of the data hold and transfer control circuit 7 which comprises a latch increment circuit 11 which holds leading address signals $AI_1$ to $AI_\ell$ supplied from outside and produces address signals $A_1$ to $A_\ell$ by successive increment of the leading address information $AI_1$ to $AI_\ell$ thus held, and an AND circuit 13 which takes a logical product of the data hold signal WC and the system clock signal SCK and produces the write signal WE.

The operation of the evaluation facilitating circuit thus constructed will now be described with reference to the figures. The following description is made at first about a case where signal levels at each node of the logical circuit 1 should be held in each of the latch circuits $h_{11}$ to $h_{nm}$ of the data hold circuit 5.

The data hold signal WC is produced from the logical circuit 1 and a logical product of the data hold signal WC thus produced and the system clock signal SCK is taken at the AND circuit 13. The resulting write signal WE from the AND circuit 13 is applied to each of the latch circuits $h_{11}$ to $h_{nm}$ in the data hold circuit 5.

Since each of the latch circuits $h_{11}$ to $h_{nm}$ is connected to each respective node of the logical circuit 1 through the data lines $D_{11}$ to $D_{nm}$, when the write signal WE is applied to each of the latch circuits $h_{11}$ to $h_{nm}$, signal levels at each node in the logical circuit 1 are applied at the same time to each of the corresponding latch circuits $h_{11}$ to $h_{nm}$ through the data lines $D_{11}$ to $D_{nm}$ and they are latched therein. Namely, the signal levels at each node in the logical circuit 1 at certain time point are at the same time latched, so that the logical conditions of the logical circuit 1 at the certain time point may be checked.

In the manner as described in the foregoing, the signal levels at each node of the logical circuit 1 are retained in the latch circuits $h_{11}$ to $h_{nm}$ and they are read out from the latch circuits designated by the leading address information $AI_1$ to $AI_\ell$ supplied to the data hold and transfer control circuit 7 from outside and are produced from the data hold circuit 5 as an output signal $D_{out}$. That is, the address information $AI_1$ to $AI_\ell$ are temporarily stored in the latch/increment circuit 11 of the data hold and transfer control circuit 7 and they are applied to the address decoder 9 of the data hold circuit 5 as address signals $A_1$ to $A_\ell$. The address decoder 9 decodes these address signals and it produces corresponding output signal $S_{ii}$. The signal level thus retained in the latch circuit $h_{ii}$ for instance, is output as an output signal $D_{out}$ when the output signal $S_{ii}$ is supplied to the latch circuit. Afterwards, the address signals $A_1$ to $A_\ell$ are successively incremented by the latch/increment circuit 11 and the signal levels retained in the latch circuits corresponding to the address signals thus incremented are produced as the output signal $D_{out}$ one by one, thus enabling the signal levels at each node in the logical circuit 1 to be successively checked.

The evaluation facilitating circuit according to the present invention may be mounted on a multi-layer wiring board and the data lines $D_{11}$, $D_{12}$ ... $D_{nm}$ for picking up the signal levels at each node in the logical circuit 1 can be wired on the topmost layer of the multi-layer wiring board (not shown), thus obviating the increase in the chip size of the integrated circuits due to the increase in the number of wirings.

In the evaluation facilitating circuit device according to the present invention, each of the latch circuits $h_{11}$ to $h_{nm}$ constructed in a matrix array is connected to each respective node of the logical circuit 1. Accordingly, when the write signal WE is applied to each of the latch circuits, the signal levels at each node can be retained in the latch circuits $h_{11}$ to $h_{nm}$ at the same time and the signal levels at each node of the logical circuit 1 can be read out by their address information and they are checked.

Moreover, in the foregoing embodiment, according to the present invention, since the logical circuit 1 to be checked and the evaluation facilitating circuit 3 are constructed independently so as to easily separate each other in its circuit construction, the evaluation facilitating circuit 3 can be manufactured independently, with the logical circuit 1 removed from it when manufacturing the evaluation facilitating circuit, except for a trial assembling of the logical circuit 1 and the evaluation facilitating circuit combined.

In addition, in the evaluation facilitating circuit according to the present invention, since a plurality of latches for latching logical signal levels at each node of a logical circuit are constructed in a matrix array, a high integration of the LSI circuits becomes possible and the conditions of each of nodes of the logical circuit to be checked can easily be carried out.

## Claims

1. An evaluation facilitating circuit device (3) for checking logical signal levels of each node of a logical circuit (1), comprising:

    a data hold circuit (5) having a plurality of latch circuits ($h_{11}$---$h_{nm}$) arranged in a matrix array for latching signal levels in the latch circuits ($h_{11}$---$h_{nm}$) in accordance with a control signal (WE) and address signals ($A_1$---$A_\ell$); and

    a data hold and transfer control circuit (7) for controlling the output of the signal level retained in the latch circuits ($h_{11}$---$h_{nm}$) of said data hold circuit (5) in accordance with a data hold signal (WC) and system clock signals (SCK), characterized in that said data hold circuit (5) receives the signal levels from each of the nodes in the logical circuit (1) to be checked and said data hold and transfer circuit (7) produces the control signal (WE) and the address signals ($A_1$---$A_\ell$) and controls the output of the signal level retained in the latch circuits ($h_{11}$---$h_{nm}$) of said data hold circuit (5) in accordance with the data hold signal (WC) from the logical circuit (1) to be checked, the system clock signals (SCK) from the logical circuit to be checked and address information (AI---AI$_\ell$) from an external source.

2. The evaluation facilitating circuit device (3) as claimed in claim 1, wherein each of the latch circuits ($h_{11}$---$h_{nm}$) is connected to each corresponding node of the logical circuit (1) to apply the signal levels occurring at each node at the same time to each of the corresponding latch circuits ($h_{11}$---$h_{nm}$).

3. The evaluation facilitating circuit device (3) as claimed in claim 1, wherein the control signal is a write signal (WE) and the signal levels at each of the nodes in the logical circuit (1) to be checked are latched in the plurality of latch circuits ($h_{11}$---$h_{nm}$) arranged in the matrix array through data lines ($D_{11}$---$D_{nm}$) when the write signal (WE) and the address signals ($A_1$---$A_\ell$) from said data hold and transfer control circuit (7) are applied to the latch circuits ($h_{11}$---$h_{nm}$).

4. The evaluation facilitating circuit device (3) as claimed in claim 1, wherein said data hold circuit (5) further comprises an address decoder (9) for receiving the address signals ($A_1$---$A_\ell$) from said data hold and transfer control circuit (7) and for decoding the address signals ($A_1$---$A_\ell$) so as to produce each output signal (Dout) corresponding to each of the address signals ($A_1$---$A_\ell$).

5. The evaluation facilitating circuit device (3) as claimed in claim 1, wherein said data hold and transfer control circuit (7) further comprises a latch/increment circuit (11) for holding and for successively incrementing the address information (AI---AI$_\ell$) supplied from the external source so as to produce the address signals ($A_1$---$A_\ell$) to be applied to the latch circuits ($h_{11}$---$h_{nm}$), and a logical product circuit (13) for receiving the data hold signal (WC) and the system clock signals (SCK) from the logical circuit (1) to be checked and for producing the write signal (WE) therefrom.

**Patentansprüche**

1. Bewertungserleichterungsschaltungseinrichtung (3) zum Überprüfen der logischen Signalpegel jedes Knotens einer logischen Schaltung (1), umfassend:
   - eine Datenhalteschaltung (5) mit einer Vielzahl von Zwischenspeicherschaltungen ($h_{11}...h_{nm}$), die in einem Matrixfeld zum Halten von Signalpegeln in den Zwischenspeicherschaltungen ($h_{11}...h_{nm}$) in Übereinstimmung mit einem Steuersignal (WE) und mit Adressiersignalen ($A_1...A_\ell$) angeordnet sind; und
   - eine Datenhalte- und Übertragungssteuerschaltung (7) zum Steuern des Ausganges der Datenhalteschaltung (5) für den in den Zwischenspeicherschaltungen ($h_{11}...h_{nm}$) zurückgehaltenen Signalpegel in Übereinstimmung mit einem Datenhaltesignal (WC) und mit Systemtaktsignalen (SCK),

   dadurch **gekennzeichnet,** daß die Datenhalteschaltung (5) die Signalpegel von jedem der Knoten der zu überprüfenden logischen Schaltung (1) empfängt, und die Datenhalte- und Übertragungsschaltung (7) das Steuersignal (WE) und die Adressiersignale ($A_1...A_\ell$) erzeugt und den Ausgang der Datenhalteschaltung (5) für den in den Zwischenspeicherschaltungen ($h_{11}...h_{nm}$) zurückgehaltenen Signalpegel in Übereinstimmung mit den von der zu überprüfenden logischen Schaltung (1) gelieferten Datenhaltesignal (WC), den von der zu überprüfenden logischen Schaltung gelieferten Systemtaktsignalen (SCK) und der von einer äußeren Quelle gelieferten Adresseninformation ($Al...Al_\ell$) steuert.

2. Bewertungserleichterungsschaltungseinrichtung (3) nach Anspruch 1, bei der jede der Zwischenspeicherschaltungen ($h_{11}...h_{nm}$) mit jedem entsprechenden Knoten der logischen Schaltung (1) verbunden ist, um die an jedem Knoten zur gleichen Zeit auftretenden Signalpegel an jede der entsprechenden Zwischenspeicherschaltungen ($h_{11}...h_{nm}$) anzulegen.

3. Bewertungserleichterungsschaltungseinrichtung (3) nach Anspruch 1, bei der das Steuersignal ein Schreibsignal (WE) ist und die an jedem der Knoten der zu überprüfenden logischen Schaltung (1) auftretenden Signalpegel über Datenleitungen ($D_{11}...D_{nm}$) in der Vielzahl der im Matrixfeld angeordneten Zwischenspeicherschaltungen ($h_{11}...h_{nm}$) festgehalten werden, wenn das Schreibsignal (WE) und die von der Datenhalte- und Übertragungssteuerschaltung (7) gelieferten Adressiersignale ($A_1...A_\ell$) an die Zwischenspeicherschaltungen ($h_{11}...h_{nm}$) angelegt werden.

4. Bewertungserleichterungsschaltungseinrichtung (3) nach Anspruch 1, bei der die Datenhalteschaltung (5) weiter einen Adressendekodierer (9) zum Empfangen der von der Datenhalte- und Übertragungssteuerschaltung (7) gelieferten Adressiersignale ($A_1...A_\ell$) und zum Dekodieren der Adressiersignale ($A_1...A_\ell$) aufweist, so daß jedes Ausgangssignal (Dout) entsprechend jedem der Adressiersignale ($A_1...A_\ell$) erzeugt wird.

5. Bewertungserleichterungsschaltungseinrichtung (3) nach Anspruch 1, bei der die Datenhalte- und Übertragungssteuerschaltung (7) weiter eine Zwischenspeicher-/Inkremetierschaltung (11) zum Halten und zum aufeinanderfolgenden Inkrementieren der von der äußeren Quelle gelieferten Adresseninformation ($AI...Al_\ell$) aufweist, so daß die an die Zwischenspeicherschaltungen ($h_{11}...h_{nm}$) anzulegenden Adressiersignale ($A_1...A_\ell$) erzeugt werden, und daß sie eine Verknüpfungsproduktschaltung (13) zum Empfangen des Datenhaltesignale (WC) und der von der zu überprüfenden logischen Schaltung (1) gelieferten Systemtaktsignale (SCK), sowie zum Erzeugen des daraus folgenden Schreibsignals (WE) aufweist.

**Revendications**

1. Dispositif (3) de circuit facilitant l'évaluation pour vérifier les niveaux de signaux logiques de chaque noeud d'un circuit logique (1), comprenant :
   - un circuit de maintien de données (5) comportant une multitude de circuits à bascule ($h_{11}....h_{nm}$) disposés dans un réseau matriciel pour enclencher des niveaux de signal dans les circuits à bascule ($h_{11}...h_{nm}$) en conformité avec un signal de commande (WE) et des signaux d'adresse ($A_1...A_\ell$); et
   - un circuit (7) de commande du maintien et du transfert de données afin de commander la sortie du niveau de signal maintenu dans les circuits à bascule ($h_{11}...h_{nm}$) dudit circuit de maintien de données (5) en conformité avec un signal de maintien de données (WC) et des signaux d'horloge de système (SCK), caractérisé en ce que ledit circuit de maintien de données (5) reçoit des niveaux de signal en provenance de chacun des noeuds du circuit logique (1) à vérifier et ledit circuit de commande du maintien et du transfert de données (7) produit le signal de commande (WE) et les signaux d'adresse $(A_1...A_\ell)$ et commande la sortie du niveau de signal maintenu dans les circuits à bascule $(h_{11}...h_{nm})$ dudit circuit de maintien de données (5) en conformité avec le signal de maintien de données (WC) provenant du circuit logique (1) à vérifier, les signaux d'horloge de système (SCK) provenant du circuit logique à vérifier et les informations d'adresses $(AI...AI_\ell)$ provenant d'une source externe.

2. Dispositif (3) de circuit pour faciliter l'évaluation selon la revendication 1, dans lequel chacun des circuits à bascule $(h_{11}...h_{nm})$ est connecté à chaque noeud correspondant du circuit logique (1) pour appliquer en même temps les niveaux de signal se produisant à chaque noeud, à chacun des circuits à bascule correspondants $(h_{11}...h_{nm})$.

3. Dispositif (3) à circuit facilitant l'évaluation selon la revendication 1, dans lequel le signal de commande est un signal d'écriture (WE) et les niveaux de signal à chacun des noeuds du circuit logique (1) à vérifier sont enclenchés dans la multitude de circuits à bascule $(h_{11}...h_{nm})$ disposés dans le réseau matriciel par l'intermédiaire de lignes de données $(D_{11}...D_{nm})$ lorsque le signal d'écriture (WE) et les signaux d'adresse $(A_1...A_\ell)$ provenant dudit circuit (7) de commande du maintien et du transfert des données sont appliqués aux circuits à bascule $(h_{11}...h_{nm})$.

4. Dispositif (3) de circuit facilitant l'évaluation selon la revendication 1, dans lequel ledit circuit de maintien des données (5) comprend en outre un décodeur d'adresses (9) pour recevoir les signaux d'adresses $(A_1...A_\ell)$ provenant dudit circuit de commande du maintien et du transfert des données (7) et pour décoder les signaux d'adresses $(A_1...A_\ell)$ de manière à produire chaque signal de sortie $(D_{out})$ correspondant à chacun des signaux d'adresses $(A_1...A_\ell)$.

5. Dispositif de circuit facilitant l'évaluation (3) selon la revendication 1, dans lequel ledit circuit de commande du maintien et du transfert des données (7) comprend en outre un circuit à bascule/incrémentation (11) pour maintenir et pour incrémenter successivement les informations d'adresses $(AI...AI_\ell)$ fournies par la source externe de manière à produire les signaux d'adresses $(A_1...A_\ell)$ devant être appliqués aux circuits à bascule $(h_{11}...h_{nm})$, et un circuit de produit logique (13) pour recevoir le signal de maintien de données (WC) et les signaux d'horloge de système (SCK) en provenance du circuit logique (1) à vérifier et pour produire le signal d'écriture (WE) à partir de ceux-ci.

# F I G . 1

# F I G . 2

# FIG.3

7

$\ell$

AI$_{1-\ell}$

11

LATCH/INCREMENT
CIRCUIT

$\ell$

A$_{1-\ell}$

13

WC

SCK

AND

WE